# EUROPEAN PATENT APPLICATION

(11) **EP 1 126 600 A2**
(43) Date of publication of application: **22.08.2001**
(21) Application number: 01301139.0
(22) Date of filing: 08.02.2001
(51) Int. Cl.: H03G 5/24, H04B 1/10

(54) **Variable resolution bandwidth control for data receiver**

(30) Priority: 10.02.2000 GB 0002945
(71) Applicant: Pace Micro Technology PLC, Shipley, West Yorkshire BD18 3LF (GB)
(72) Inventor: Coe, Peter W., Skipton, North Yorkshire BD23 2TE (GB)
(74) Representative: Wood, Graham

(57) **Abstract**

The invention relates to apparatus and a control system for use with receivers for the reception of digital data which is broadcast from a remote location, typically by television broadcast companies. The invention provides a reduced cost of manufacture and parts and greater commonality between receivers for selective use in various marketplaces and customers. The invention relates to the provision of at least two bandwidth filters selectively operable and selectively operable at different IF frequencies. Control means are provided for selectively rendering one or the other of said filters operable to allow the provision of a receiver with selective variable resolution bandwidth and to allow the selective dual up down conversion.

## Description

The invention to which this application relates is a control system for use with receivers for the reception of digital data and particularly although not necessarily exclusively for the reception of data which is broadcast from a remote location, typically by television broadcast companies and particularly, although not necessarily exclusively, to receivers for community antenna television (CATV) systems and digital terrestrial television systems (DTT).

In order for CATV and DTT system receivers to operate successfully, and to be operable in a number of different market places with system variance, a number of different intermediate frequency (IF) resolution bandwidths are required to be available for selection so that the receivers can be operable with respect to different RF modulation signal bandwidths which may be operated by different broadcast systems. The system operating requirements change from marketplace to marketplace and country to country. Conventionally to ensure that a receiver will operate in a particular marketplace receivers are manufactured for specific markets and typically provided with fixed bandwidth filters which have no ability or capacity for change of the IF bandwidth. While this may be appropriate for specific markets, it is inconvenient to the manufacturer of the receivers in that they are required to fit different systems for different market places and, also, requires work to be undertaken in respect of each new market in combination with the data broadcasters, to ensure that the correct system is implemented for each particular market place.

As, conventionally, receivers are provided with fixed IF bandwidth filters, the receivers are restricted with respect to a maximum bandwidth of a single received signal but there is no provision for restriction of signals which are less than the filter or bandwidth. It is also known to be able to perform dual down conversion techniques for mobile telephone systems but the same cannot be used to provide the advantages as herein described and furthermore the known techniques only allow adjustment of the bandwidth in one direction.

The aim of the present invention is to provide a filter design for receivers which allows for variable resolution bandwidth control in the receivers and which, in turn, allows greater commonality to be achieved in the design and manufacture of receivers for different market places as the invention allows adjustment of the same to suit particular market requirements.

In a first aspect of the invention there is provided a receiver for receiving digital data which is broadcast from a remote location, said receiver provided with a means for decoding the received data, processing the same and generating a video display on a display screen connected thereto, said receiver including an intermediate frequency resolution bandwidth operable with an IF modulation signal bandwidth and characterised in that the receiver includes at least two bandwidth filters in a cascaded arrangement and selectively operable at different IF frequencies and control means for selectively rendering one or the other of said filters operable and/or selectively controlling the operation of the same to allow the provision of a receiver with selective variable resolution bandwidth and said selection allowing dual IF up down conversion of bandwidth.

In this arrangement in accordance wit the invention the first and second local oscillators are misaligned.

Preferably, the bandwidth filters which are used are surface acoustic wave (SAW) filters. It is envisaged that two of said filters will be sufficient to allow the invention to be utilised and that each of the filters used can be operated at different IF frequencies.

The control means for the receiver allows change of the local oscillator (LO) conversion frequency from one intermediate frequency (IF) to the other of the filters.

Typically the two different Intermediate Frequency (IF) filters are band pass filters. However in alternative embodiments any or any combination of band stop, high pass or low pass filters can be used in combination or in combination with a band pass filter.

In one embodiment, if a band stop filter is used as one of the filters then this can be used to not only produce a variable bandwidth but also create a greater degree of rejection on one side of the system band pass response.

Typically the use of the filters in accordance with the invention allows the option of conversion of the operation of the receiver to accommodate and receive variable resolution bandwidths to suit particular market operating requirements. The adjustment and setting of the operation of the same will typically take place at the factory or at the time of installation of the receiver in the location of use.

The ability to provide dual up or down conversion process is a significant advantage and greatly improves the ability for the manufacturer to produce a receiver which is universal inasmuch that it can be set to meet a range of different operating conditions.

In one embodiment a tuneable band pass filter may be used at the first IF filter stage of the system. One such filter design is a Printed Circuit Board (PCB) inter-digital band pass filter. Typically, in order to take account potential variability of the PCB material and the copper etching tolerance the ability for tuning the filter is provided.

In one embodiment the tuning can be performed electronically by adjusting the inductive tuning elements of the filter, thus enabling the filter to be set up automatically during manufacture. In one embodiment this set up can be achieved by the performance of a self calibration test by the RF front-end of a receiver.

Ina further aspect of the invention there is provided a system for receiving and processing data broadcast from a remote location and allowing the selection of a bandwidth range from an available range, characterised in that said system comprises including in said receiver the means to operate an intermediate frequency(IF) resolution bandwidth operable with an IF modulation signal bandwidth said receiver including at least two bandwidth filters each selectively controllable to operate at a particular IF frequency and said system includes control means for selectively rendering one or the other of said filters operable or selectively controlling the frequency level of operation of the same to allow the selection and variation of the resolution bandwidth of the receiver in up and down directions to suit particular operating requirements.

Specific embodiments of the invention are now described with reference to the accompanying diagrams; wherein
Figure 1 illustrates a circuit in accordance with one embodiment of the invention;
Figures 2a and b illustrate amplitude versus bandwidth graphs indicating alignment and non alignment conditions;
Figure 3 illustrates the result of a band pass and band stop filter combination;
Figure 4 illustrates the result of a high pass and low pass filter combination; and
Figure 5 illustrates the use of a tuneable electronic filter.

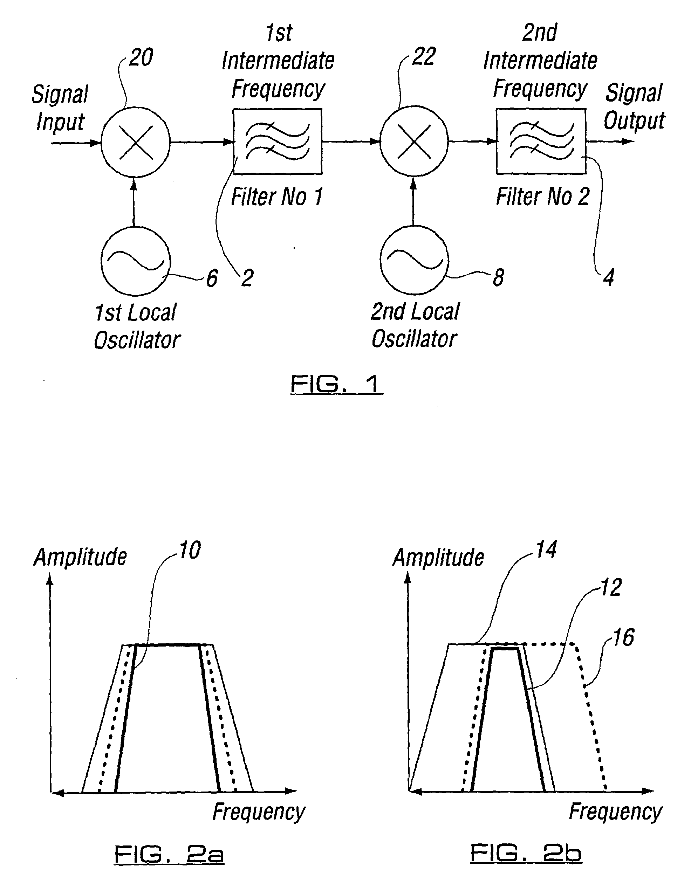

Referring now to the figures, in a receiver in accordance with the current invention, there is provided a first IF filter 2 and a second IF filter 4, both of which, in this embodiment, are provided as surface acoustic wave filters. This form of filter is known to provide a "very steep" bandwidth cut off so as to provide the clear definition of the bandwidth restriction. Conventionally the first and second Local Oscillators 6, 8 are aligned such that the IF filters are centred on each other and the received signal passes though the centre of each filter. The result of this conventional approach is as illustrated in Figure 2a wherein the received resolution signal bandwidth illustrated by the bold line 10 is particularly constrained by the cascaded summation of the two filter bandwidths .

However in accordance with the current invention the local oscillator 6,8 of either or both of the first or the second converter stage can be adjusted such that they are misaligned. The result of this is as illustrated in Figure 2b by the bold line 12 wherein there is a narrower bandwidth resolution combination where the bandwidth 14 of filter 2 overlaps with the bandwidth 16 of the filter 4, that is the received signal does not pass though the centre of the IF filters but to one side (off set) of each. Thus the signal received by the receiver passes between the upper edge cut-off of the IF filter 2 and the lower edge of the IF filter 4. Thus, the received signal is passed through a reduced resolution bandwidth as the cascaded summation of the two filter bandwidths is less than (narrower) the resolution bandwidth of either IF filter 2,4.

The degree of frequency misalignment of the local oscillators can be adjusted to determine the final resolution bandwidth realised.

The adjustment between the IF filters allows the variable resolution bandwidth to be achieved and this use can be incorporated in, for example, a receiver which is provided with two receiver channels, one with a fixed 8MHz bandwidth which is allocated to a particular set of programme channels, the other with a 2MHz bandwidth allocated to a second set of channels. In this example it is typically not possible to have two data or programme channels received, as the data channels bandwidth is too narrow to let enough signal through and the video channel is too wide and allows too many channels through for the required signal to be defined from all the others. However, the provision of the two IF filters in accordance with this invention allows the adaptation and control of the data channels to be variable and therefore allows variation by the manufacturer in the control of operation of each of the filters. This variation can be provided to allow two data or two programme channels to be received by variation of the filter control.

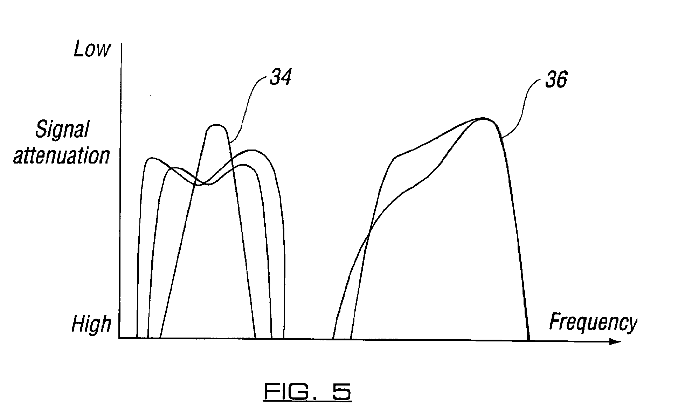

Furthermore, in accordance with the invention the system can be used to provide dual up down IF conversion which is not achieved by any known prior art devices. In this case the received signal is first up converted at the first mixer 20 of Figure 1 and then down converted at the second mixer 22. Thus in accordance with the invention the first and second local frequency oscillators can be adjusted in the same direction i.e. up or down or may be independently adjusted . Figure 4 illustrates the result of a narrower band pass response which can be achieved by using a band pass IF filter adjusted at a low value 30 and a second IF filter at a high value 28. In this case there is created a narrower bandwidth response indicated by the hatched area 32 than would be the case if either filter was used individually and the same can be adjusted to suit particular operating parameters.

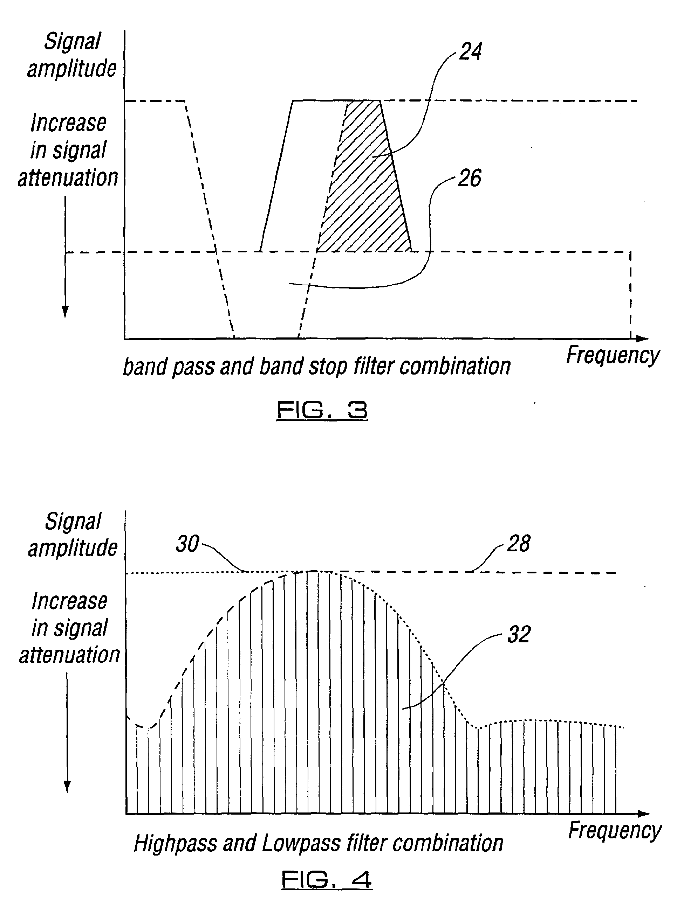

The If filters used are in many cases the band pass type of filter however this need not always be the case and they can be selected to be any combination of bandpass, band stop, high pass or low pass filters. Figure 3 illustrates the graphical results when a band stop filter is used as one of the filters, with the other being a band pass filter. In this case the same can be adjusted to provide a variable bandwidth then this can be used to not only produce a variable bandwidth 24 but also create greater rejection 26 on one side of the system band pass response.

In a further feature of the invention a tuneable band pass filter may be used at the first IF filter stage 2. The cost of fixed band pass filters such as SAW and Ceramic are high but offer good Q and thus channel selectivity, however this is not altogether needed in most designs and filters with lower Q which still offer an acceptable degree of channel filtering can be used in accordance with the invention. One such filter design is a PCB inter-digital band pass filter. With this form of filter, the variability of PCB material and the copper etching tolerance prevent the filter frequency response to be accurately set in terms of absolute centre frequency, absolute bandwidth and band pass shape/response. Thus in order to correct this an element of tuning must be introduced.

This tuning can be electronic by placing varactor diodes on the inductive tuning elements of the filter, thus enabling the filter to be set up automatically in production and during a self calibration by the RF front-end of a set top box. In addition, by introducing electronic tuning it is possible to provide a degree of in channel amplitude distortion correction, indeed even providing greater rejection of power from adjacent and unwanted channels to that which is/are being received. This can be achieved by the receiver control software mistuning the filter thus adding amplitude predistortion to the IF signals. Figure 5 illustrates one example of this feature wherein a two tuneable pole filter is used with each pole 34, 36 controlled to be moved away from each other to form variable bandwidth and amplitude slope and in this case, at each pole, each line indicates system filter responses which are possible using the electronic filter tuning procedure.

The invention therefore provides a reduced cost of manufacture and parts and greater commonality between receiver devices for various marketplaces and customers. The use of the two IF filters for all receivers rather than providing fixed bandwidth filters allows variation and optimisation of the control of the filters for differing marketplaces and customers.

## Claims

1. A receiver for receiving digital data which is broadcast from a remote location, said receiver provided with a means for decoding the received data, processing the same and generating a video display on a display screen connected thereto, said receiver including an intermediate frequency resolution bandwidth operable with an IF modulation signal bandwidth and characterised in that the receiver includes at least two bandwidth filters in a cascaded arrangement and selectively operable at different IF frequencies and control means for selectively rendering one or the other of said filters operable and/or selectively controlling the operation of the same to allow the provision of a receiver with selective variable resolution bandwidth and said selection allowing dual IF up down conversion of bandwidth.

2. A receiver according to claim 1 characterised in that the first and second local oscillators are misaligned.

3. A receiver according to claim 1 characterised in that the bandwidth filters are surface acoustic wave (SAW) filters.

4. A receiver according to claim 3 characterised in that said receiver includes two of said filters, each operable at different IF frequencies.

5. A receiver according to claim 1 characterised in that the control means for the receiver allow selective change of the local oscillator (LO) conversion frequency from one intermediate frequency (IF) of one filter to an intermediate frequency of another filter.

6. A receiver according to claim 1 characterised in that the two Intermediate Frequency (IF) filters are band pass filters.

7. A receiver according to claim 1 characterised in that the Intermediate Frequency Filters (IF) used are any or any combination of band pass, band stop, high pass or low pass filters.

8. A receiver according to claim 7 characterised in that one of the filters is a band stop filter which is used to produce a variable bandwidth and create a greater degree of rejection on one side of the system band pass response than the other side.

9. A receiver according to claim 1 characterised in that the adjustment and setting of particular operating parameters of the filters is performed at the time of manufacture.

10. A receiver according to claim 1 characterised in that the adjustment and setting of particular operating parameters of the filters is performed at the time of installation of the receiver in the location of use.

11. A receiver according to claim 1 characterised in that a tuneable band pass filter is provided as one of the IF filters.

12. A receiver according to claim 11 characterised in that the tuneable band pass filter is a Printed Circuit Board (PCB) inter-digital band pass filter.

13. A receiver according to claim 12 characterised in that the tuning of the filter is performed electronically via adjustment of inductive tuning elements provided as part of the filter.

14. A system for receiving and processing data broadcast from a remote location and allowing the selection of a bandwidth range from an available range, characterised in that said system comprises including in said receiver the means to operate an intermediate frequency(IF) resolution bandwidth operable with an IF modulation signal bandwidth said receiver including at least two bandwidth filters each selectively controllable to operate at a particular IF frequency and said system includes control means for selectively rendering one or the other of said filters operable or selectively controlling the frequency level of operation of the same to allow the selection and variation of the resolution bandwidth of the receiver in up and down directions to suit particular operating requirements.
